# EUROPEAN PATENT SPECIFICATION

(11) **EP 2 267 181 B1**
(45) Date of publication and mention of the grant of the patent: **04.12.2013**
(21) Application number: 09727568.9
(22) Date of filing: 04.03.2009
(51) Int. Cl.: C23C 14/32

(54) **TARGET EXCHANGE TYPE PLASMA GENERATOR**
TARGETAUSTAUSCH-PLASMAGENERATOR
GÉNÉRATEUR DE PLASMA DE TYPE À ÉCHANGE DE CIBLE

(30) Priority: 31.03.2008 JP 2008094418
(43) Date of publication of application: 29.12.2010
(73) Proprietor: Ferrotec Corporation, Tokyo 104-0031 (JP)
(72) Inventor: SHIINA, Yuichi, Tokyo 104-0031 (JP)
(74) Representative: Patentanwälte Olbricht Buchhold Keulertz
(86) International application number: PCT/JP2009/054015
(87) International publication number: WO 2009/122846

(56) References cited:
- JP-A- 3 173 767
- JP-A- 3 173 767
- JP-A- 10 147 863
- JP-A- 62 167 874
- JP-A- 2005 240 182
- JP-A- 2007 016 269
- US-A1- 2005 199 487
- US-B1- 6 319 369

## Description

### FIELD OF THE INVENTION

The present invention concerns a plasma generating apparatus that generates plasma by vacuum arc discharge. More specifically, it concerns a target exchange type plasma generating apparatus in which supply sources of vacuum arc plasma (henceforth referred to as "targets") are multiply installed, and a target exchanging mechanism is comprised, in which the positions of the target that has been installed as an electrode at the electric discharge position and the target whose electric discharge surface has been polished at the polishing position are exchanged.

### BACKGROUND ART

It has been known that the surface characteristics of a solid are improved by forming a film on or injecting ions in the surface of the solid material in plasma. Films that were formed using plasma that includes metal and/or nonmetal ions strengthen the abrasion and corrosion resistances of solid surfaces, and are useful as protective films, optical thin films, and transparent electroconductive films among others. As a method to generate plasma that includes metal and/or nonmetal ions, there is a vacuum arc plasma method. In this vacuum arc plasma method, an arc spot is formed in a vicinity of the electric discharge surface, by an arc discharge that arises between the electric discharge surface of the target that is the cathode and the anode. The arc spot becomes self-sustaining upon supplying of a predetermined arc current, and vacuum arc plasma comprising ions of the target material (henceforth simply called "plasma") is ejected from the arc spot. The arc spot becomes unstable when a hole formed by evaporation / weathering (erosion) of the target material exists on the electric discharge surface (henceforth referred to as "pore"), and a larger arc current becomes necessary to maintain the arc spot. Therefore, in a conventional plasma generator, when the electric discharge surface of a target became worn out by formation of pores, it was necessary to interrupt temporarily the intermittent generation of plasma, open the vacuum chamber, and exchange the target. To achieve the necessary degree of vacuum again, a time greater than 1 day was often necessary.

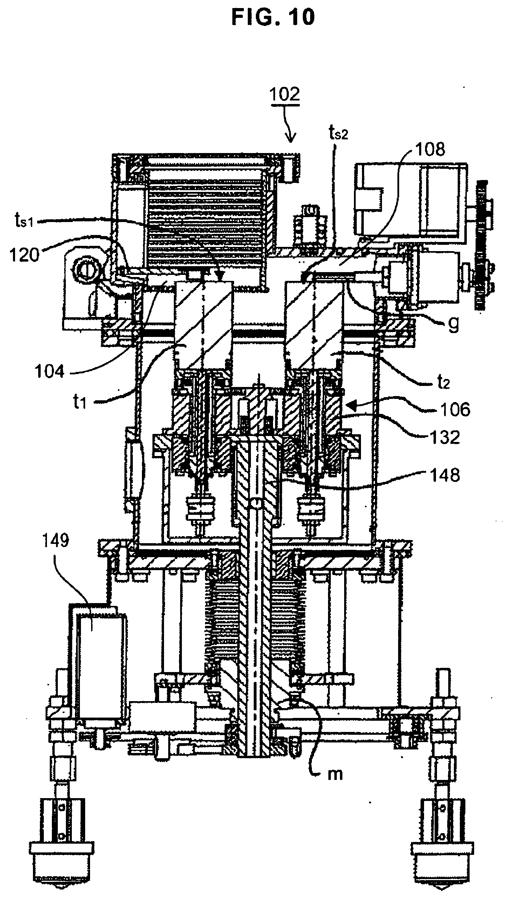

In the Japanese Patent Laid-Open No. 2005-240182 bulletin (Patent Document 1), a conventional target exchange type plasma generating apparatus is described, in which two targets are provided side-by-side to make a long, continuous use possible, and the positions of the target whose electric discharge surface became worn out by generation of vacuum arc plasma, and the target on which the polishing of the electric discharge surface has been completed, can be exchanged in the same vacuum chamber. FIG. 10 is a cross-sectional view of the conventional target exchange type plasma generating apparatus described in Patent Document 1. In the conventional target exchange type plasma generating apparatus 102, first target t₁ is arranged in plasma generating portion 104 where striker 120 has been set up, and second target t₂ is arranged in target polishing portion 108 where a polishing device comprising grinder g has been set up. Under a condition in which current flows between electric discharge surface T_{S1} of first target t₁ and striker 120 in contact with the former, generation of plasma is induced by separating striker 120 from electric discharge surface T_{S1}. That is to say, first target t₁ and second target t₂ are placed on holder 132 that comprises target exchanging means 106, first target t₁ is at the electric discharge position, and second target t₂ is at the polishing position. Said holder 132 comprises rotating shaft 148, and it can be rotated by means of rotating mechanism m. Therefore, the positions can be exchanged between first target t₁ depleted by generation of plasma, and second target t₂ that is unused, or on which trimming such as polishing treatment has been applied to electric discharge surface T_{S2}.
[patent document 1] Japanese Patent Laid-Open No. 2005-240182 bulletin

Furthermore, there is known an arc deposition apparatus comprising an evacuatable chamber and means for positioning at least two targets in the chamber, wherein a first one of the at least two targets is positionable in an operative position and another of the at least two targets is positionable in a standby position (US 2005/0199487 A1). An electrical power supply is provided for supplying electrical power to the target held in the operative position to form an arc on an emission surface of the operative target. Means are provided for preparing an emission surface of the target positioned in the standby position to have a predetermined morphology. Alternatively, or in conjunction with the surface preparing means, means are provided for inspecting whether the emission surface of the target positioned in the standby position has a predetermined morphology.

### DISCLOSURE OF THE INVENTION

### PROBLEMS TO BE SOLVED BY THE INVENTION

In the conventional target exchange type plasma generating apparatus shown in FIG. 10, the position of holder 132 set up on rotating shaft 148 was varied up or down by a single height control device 149, and the height positions of first target t₁ and second target t₂ were thus adjusted. Also, in a conventional target exchange type plasma generating apparatus same as FIG. 10, when first target t₁ and second target t₂ were spun, it was done by a single driving means. That is to say, it was impossible to change in an independent manner the height of the two targets in the electric discharge and the polishing positions, the contact position of striker 120 with respect to electric discharge surface T_{S1}, or the trimming position of electric discharge surface T_{S2}. Therefore, a fine adjustment according to the quantity of consumption of each target or the necessary arc current was not possible. However, because plasma is generated using either target necessarily, and a difference occurs between the quantities of consumption by the polishing treatment of the two targets, there was a demand for adjusting the height of multiple targets by raising and lowering them independently, and controlling the spinning of the targets. In particular, there were cases that a great difference occurred in the quantity of consumption of targets, when two kinds of targets with differing compositions were arranged.

Therefore, the object of the present invention is to offer a target exchange type plasma generating apparatus in which the positions of the targets in the electric discharge position and the polishing position can be exchanged, and the positions of the two targets can be adjusted independently.

### MEANS TO SOLVE THE PROBLEM

The present invention has been proposed to solve the above problem, and the first form of the present invention is a target exchange type plasma generating apparatus comprising a plasma generating portion that generates plasma by a vacuum arc discharge between a target becoming a cathode and an anode under a vacuum environment, a target polishing portion that polishes an electric discharge surface of said target, and a target exchanging mechanism that exchanges the positions of a target positioned at an electric discharge position of said plasma generating portion and a target positioned at a polishing position of said target polishing portion, wherein said target exchanging mechanism comprises a main holder half-rotated by a main motor, two containing portions installed in opposite positions along the diameter direction of said main holder, two auxiliary holders contained rotatably in said two containing portions, two auxiliary motors spinning said two auxiliary holders, two sliders raising and lowering said two auxiliary holders in the spinning shaft direction, and said two targets engaged in said two auxiliary holders, where the positions of said targets are exchanged by half-rotating said main holder, and said two targets are independently driven so that they are raised, lowered, and spun to said electric discharge position and said polishing position when said main holder is stationary.

The second form of the present invention is the target exchange type plasma generating apparatus of the first form, wherein connecting means removable from said auxiliary holders are installed at tips of said spinning shafts, said auxiliary motors and said sliders are separated from said main holder at the detachment time of said connecting means, the positions of said targets are exchanged by half-rotating only said main holder that has received said auxiliary holders, said auxiliary holders are separated from said main holder by raising said spinning shafts at the engagement time of said connecting means, and each of said two targets are independently deployed at said electric discharge position and said polishing position. J

The third form of the present invention is the target exchange type plasma generating apparatus of the second form, wherein said connecting means comprises a chuck mechanism.

The fourth form of the present invention is the target exchange type plasma generating apparatus of the first form, wherein said auxiliary holders are fastened to tips of said spinning shafts, each of said two targets are positioned independently at said electric discharge position and said polishing position by raising said spinning shafts and separating said auxiliary holders from said main holder, said auxiliary holders are contained inside said containing portions of said main holder by lowering said spinning shafts, and said auxiliary motors and said sliders are half-rotated as a whole upon exchanging the positions of said targets by half-rotating said main holder.

The fifth form of the present invention is the target exchange type plasma generating apparatus of any one of the first to fourth forms, wherein said plasma generating portion is positioned in a plasma generation chamber sealed by an electric discharge partition wall when said target is positioned at said electric discharge position, said target polishing portion comprising a polishing device is positioned in a target polishing chamber sealed by a polishing partition wall when said target is positioned at said polishing position, and grinding powder that is ejected by said polishing device from said target is sealed in said polishing chamber.

The sixth form of the present invention is the target exchange type plasma generating apparatus of any one of the first to fifth forms, wherein said plasma generating portion is formed inside of an electrically neutral outer wall and an anode inner wall installed at the inner side of said outer wall.

The seventh form of the present invention is the target exchange type plasma generating apparatus of the sixth form, wherein a target coil is positioned at the outer circumference of said outer wall tube at a vicinity position of said target, a filter coil is positioned at the plasma outlet side of said plasma generating portion, and a stabilizing magnetic field that is generated by said target coil is formed in reverse-phase (cusp) or in-phase (mirror) of a plasma advancing magnetic field that is generated by said filter coil.

The eighth form of the present invention is the target exchange type plasma generating apparatus of any one of said first to seventh forms, wherein a striker that induces an arc discharge on said electric discharge surface of said target is positioned at a vicinity of the target positioned at said electric discharge position of said plasma generating portion, said striker is rotated around a fulcrum by a rotating means, and abutting of said striker tip against said electric discharge surface is detected by measuring the torque reaction force on said striker.

### EFFECTS OF THE INVENTION

According to the first form of the present invention, because said target exchanging mechanism comprises a main holder half-rotated by a main motor, two containing portions installed in opposite positions along the diameter direction of said main holder, two auxiliary holders contained rotatably in said two containing portions, two auxiliary motors spinning said two auxiliary holders, two sliders raising and lowering said two auxiliary holders in the spinning shaft direction, and said two targets engaged in said two auxiliary holders. Because of this, the positions of said targets can be exchanged by half-rotating said main holder, and at the same time, said two targets can be independently driven so that they are raised, lowered, and spun to said electric discharge position and said polishing position when said main holder is stationary. That is to say, the main holder and the auxiliary holder are comprised so that they are driven independently, and for each target, the positional relation with the striker in the plasma generating portion or the grinder in the target polishing portion can be set at a suitable position. Also, by spinning each target independently, the contact location of the striker and the electric discharge surface, as well as the position of trimming, can be adjusted appropriately. In addition, for the motor, various kinds of driving means, such as an electric motor and an air cylinder-driven actuator, can be used. Therefore, even when a difference occurs in the quantities of consumption by the polishing treatment of the two targets, these two targets can be arranged at positions suitable for vacuum arc discharge or polishing treatment, through a height adjustment in which the targets are independently raised and lowered. In addition, polishing treatment is a trimming of the electric discharge surface of an exhausted target in a configuration designed beforehand, and it includes various methods. For example, aside from grinding, a method such as electropolishing can be used.

According to the second form of the present invention, connecting means removable from said auxiliary holders are installed at tips of said spinning shafts, said auxiliary motors and said sliders are separated from said main holder at the detachment time of said connecting means, the positions of said targets are exchanged by half-rotating only said main holder that has received said auxiliary holders, and said auxiliary holders can be separated from said main holder by raising said spinning shafts at the engagement time of said connecting means. Therefore, the targets can be exchanged without half-rotating said spinning shaft, said auxiliary motors, and said sliders along with said main holder, and the structure of the main holder can be relatively simplified. Because of this, the durability of the apparatus can be improved.

According to the third form of the present invention, because said connecting means comprises a chuck mechanism, said auxiliary holders can be attached to and detached from the tips of said spinning shafts more reliably. That is to say, through opening and closing of the chuck mechanism, the auxiliary holders and the spinning shafts can be attached and detached by a comparatively simple operation.

According to the fourth form of the present invention, said auxiliary holders are fastened to tips of said spinning shafts, each of said two targets are positioned independently at said electric discharge position and said polishing position by raising said spinning shafts and separating said auxiliary holders from said main holder, said auxiliary holders are contained inside said containing portions of said main holder by lowering said spinning shafts, and said auxiliary motors and said sliders can be half-rotated as a whole upon exchanging the positions of said targets by half-rotating said main holder. Because said auxiliary holders are fixed at the tips of said spinning shafts, abrasion of mechanical parts and generation of impurities accompanying attachment and detachment of said spinning shafts and said auxiliary holders can be minimized. Also, just as in the first form, said two targets can be independently driven so that they are raised, lowered, and spun to said electric discharge position and said polishing position when said main holder is stationary.

According to the fifth form of the present invention, said plasma generating portion is positioned in a plasma generation chamber sealed by an electric discharge partition wall when said target is positioned at said electric discharge position, said target polishing portion comprising a polishing device is positioned in a target polishing chamber sealed by a polishing partition wall when said target is positioned at said polishing position, and grinding powder that is ejected by said polishing device from said target is sealed in said polishing chamber. Because of this, the plasma generating portion can be maintained in a cleaner state. That is to say, it is doubly shielded by the electric discharge partition wall and the polishing partition wall, and a clean state can be maintained for a longer time. Also, a receiving portion for collecting the grinding powder can be set up at the upper side of the main holder.

According to the sixth form of the present invention, because said plasma generating portion is formed inside of an electrically neutral outer wall and an anode inner wall installed at the inner side of said outer wall, the safety of the plasma generating apparatus can be improved. That is to say, voltage is not applied on the outer wall of the plasma generating apparatus, and handling of this apparatus can be done relatively safely.

According to the seventh form of the present invention, a target coil is positioned at the outer circumference of said outer wall tube at a vicinity position of said target, a filter coil is positioned at the plasma outlet side of said plasma generating portion, and a stabilizing magnetic field that is generated by said target coil is formed in reverse-phase (cusp) or in-phase (mirror) of a plasma advancing magnetic field that is generated by said filter coil. Because of this, the plasma stabilization or the generation efficiency of plasma can be improved appropriately. There are cases where the generated vacuum arc oscillates on the electric discharge surface and becomes unstable, but results have been obtained where the vacuum arc is stabilized by application of a reverse-phase (cusp) magnetic field with respect to the plasma magnetic field, and plasma can be generated more stability. Also, when an in-phase (mirror) magnetic field is formed, the generation efficiency of the plasma can be improved.

According to the eighth form of the present invention, a striker that induces an arc discharge on said electric discharge surface of said target is positioned at a vicinity of the target positioned at said electric discharge position of said plasma generating portion, said striker is rotated around a fulcrum by a rotating means, and abutting of said striker tip against said electric discharge surface is detected by measuring the torque reaction force on said striker. Because of this, polishing treatment can be done highly efficiently. Previously, there were many cases where the striker came in contact with the electric discharge surface by the gravity or the inertia from a force applied at the time of drive, but by holding a constant torque and measuring the torque reaction force at the time of contact, the contact by the striker can be detected highly accurately.

### BRIEF DESCRIPTION OF THE DRAWINGS

FIG. 1 is a schematic cross-sectional view of a target exchange type plasma generating apparatus concerning the present invention.
FIG. 2 is an apparatus schematic cross-sectional view of the target exchange type plasma generating apparatus concerning the present invention, in a case that two auxiliary holders are received into a main holder.
FIG. 3 is an apparatus schematic cross-sectional view of the target exchange type plasma generating apparatus concerning the present invention, in a case that two holders are fixed to each spinning shaft.
FIG. 4 is an apparatus schematic cross-sectional view of the target exchange type plasma generating apparatus of FIG. 3, in a case that the auxiliary holders are received in the main holder.
FIG. 5 is a schematic cross-sectional view of the periphery of plasma generating portion 4 of the target exchange type plasma generating apparatus concerning the present invention.
FIG. 6 is a schematic cross-sectional view of a plasma processing apparatus to which the target exchange type plasma generating apparatus concerning the present invention has been set up.
FIG. 7 is an explanatory drawing of a movement process in the target exchange type plasma generating apparatus concerning the present invention.
FIG. 8 is an explanatory drawing of a movement process in the target exchange type plasma generating apparatus concerning the present invention.
FIG. 9 is an explanatory drawing of a movement process in the target exchange type plasma generating apparatus concerning the present invention.
FIG. 10 is a cross-sectional view of a conventional target exchange type plasma generating apparatus.

### DENOTATIONS OF REFERENCE NUMERALS

- 2: Target exchange type plasma generating apparatus
- 3: Object to be treated
- 4: Plasma generating portion
- 6: Target exchanging mechanism
- 8: Target polishing portion
- 10: Polishing device
- 12: Polishing portion outer wall
- 16: First auxiliary holder
- 18: Second auxiliary holder
- 20: Striker
- 20a: Striker
- 20b: Striker
- 21: Swinging mechanism
- 23: Striker containing portion
- 24: Anode inner wall
- 25: Electric discharge partition wall
- 26: Outer wall
- 28: Target coil
- 30: First connecting portion
- 31: Second connecting portion
- 32: Main holder
- 32a: First containing portion
- 32b: Second containing portion
- 33: Outer wall
- 34: Grinder
- 35a: Insulation member
- 35b: Insulation member
- 36: Grinder rotating shaft
- 37: Power supply
- 38: Polishing partition wall
- 39: Electric wire
- 40: Electric wire
- 42: First spinning shaft
- 42a: First chuck
- 43: First spinning shaft mechanism
- 44: Second spinning shaft
- 44a: Second chuck
- 45: Second spinning shaft mechanism
- 48: Rotating shaft
- 50: Filter coil
- 51: Bending portion
- 52: Bending magnetic field generator
- 53: Aperture
- 54: Plasma advancing path
- 55: Advancing path outer wall
- 56: Droplet advancing path
- 56a: Droplet collecting portion
- 58: Second advancing path
- 59: Baffle
- 62: First magnetic field generator
- 66: Radially enlarged tube
- 66a: Baffle
- 68: Second magnetic field generator
- 70: Third advancing path
- 71: Third magnetic field generator
- 74: Plasma processing portion
- 102: Target exchange type plasma generating apparatus
- 104: Plasma generating portion
- 106: Target exchanging mechanism
- 108: Target polishing portion
- 116: First auxiliary holder
- 118: Second auxiliary holder
- 120: Striker
- 132: Main holder
- 142: First spinning shaft
- 144: Second spinning shaft
- 148: Rotating shaft
- B1: Stabilizing magnetic field
- B2: Plasma advancing magnetic field
- D: Droplets
- G: Grinder
- g: Grinder
- M: Main motor
- M₁: First auxiliary motor
- M₂: Second auxiliary motor
- M_{G}: Motor for grinder
- m: Rotating mechanism
- P: Plasma
- S₁: First slider
- S₂: Second slider
- T₁: First target
- T₂: Second target
- T_{S1}: Electric discharge surface
- T_{S2}: Electric discharge surface
- t₁: First target
- t₂: Second target
- t_{S1}: Electric discharge surface
- t_{S1}: Electric discharge surface

### BEST MODE FOR CARRYING OUT THE INVENTION

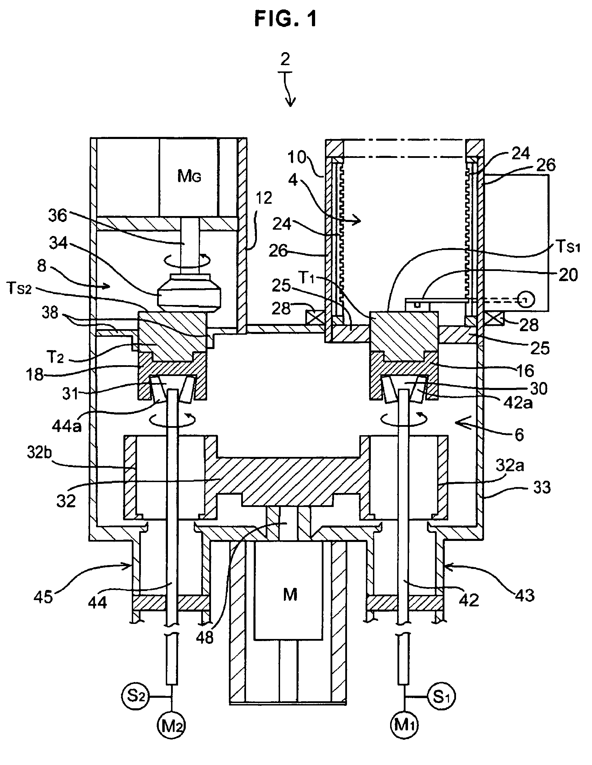

FIG. 1 is a cross-sectional view of target exchange type plasma generating apparatus 2 concerning the present invention. Target exchange type plasma generating apparatus 2 concerning the present invention comprises plasma generating portion 4 that has the electric discharge surface of the first target, target polishing portion 8 that has electric discharge surface T_{S2} of second target T₂, and target exchanging mechanism 6 that exchanges these targets. At plasma generating portion 4, when striker 20 is separated from electric discharge surface T_{S1} of target T₁ as a step previous to generating vacuum arc plasma between electric discharge surface T_{S1} of target T₁ and anode inner wall 24, an electric spark arises, inducing generation of plasma. Although not shown, in striker 20, a measuring means is set up for measuring the torque reaction force by rotating this striker 20 around the fulcrum, enabling the detection of the tip of striker 20 abutting against electric discharge surface T_{S1}. In addition, a pore is formed by electric discharge surface T_{S1} when plasma is generated. That is to say, target material in the pore evaporates, and forms plasma. Furthermore, plasma generating portion 4 is covered with outer wall 26, and target coil 28 that generates the stabilizing magnetic field described later is installed.

In said target polishing portion 8, grinder 34 is connected to a driving means, namely motor M_{G} for the grinder, through grinder rotating shaft 36, and electric discharge surface T_{S2} of target T₂ can be polished by grinder 34. By doing a polishing treatment on electric discharge surface T_{S2} with target polishing portion 8, it can remove the pores of electric discharge surface T_{S2} formed by generation of plasma. Furthermore, target polishing portion 8 is covered with polishing portion outer wall 12 and polishing partition wall 38, and even when polishing treatment is done on electric discharge surface TS2, ejection of grinding powder and such from target polishing portion 8 to another location in the vacuum chamber can be prevented or suppressed.

Target exchanging mechanism 6 of FIG. 1 is installed inside outer wall 33 of the vacuum chamber, and it comprises main holder 32 driven to half-rotation by main motor M, first containing portion 32a and second containing portion 32b installed in opposite positions along the diameter direction of this main holder 32, and a first auxiliary holder and a second auxiliary holder that can be received in these containing portions in a freely rotatable manner. Furthermore, first spinning shaft 42 is connected to first auxiliary motor M₁, second spinning shaft is connected to second auxiliary motor M₂, and two auxiliary holders, together with removable first chuck 42a and second chuck 44a, are installed on tips of these spinning shafts. In the figure, first chuck 42a is inserted into first joint 30 of first auxiliary holder 16, second chuck 44a is inserted into second joint 31 of the second auxiliary holder, and each spinning shaft and each auxiliary holder are thus coupled. Therefore, first target T₁ that is engaged to first auxiliary holder 16 can be rotated when first spinning shaft 32a is rotated by first auxiliary motor M₁, and in a similar manner, second target T₂ can be rotated by the drive of second auxiliary motor M₁. Furthermore, first slider S₁ that raises and lowers first spinning shaft 42 and second slider S₂ that raises and lowers second spinning shaft 44 are installed, and each independently can raise and lower first target T₁ and second target T₂.

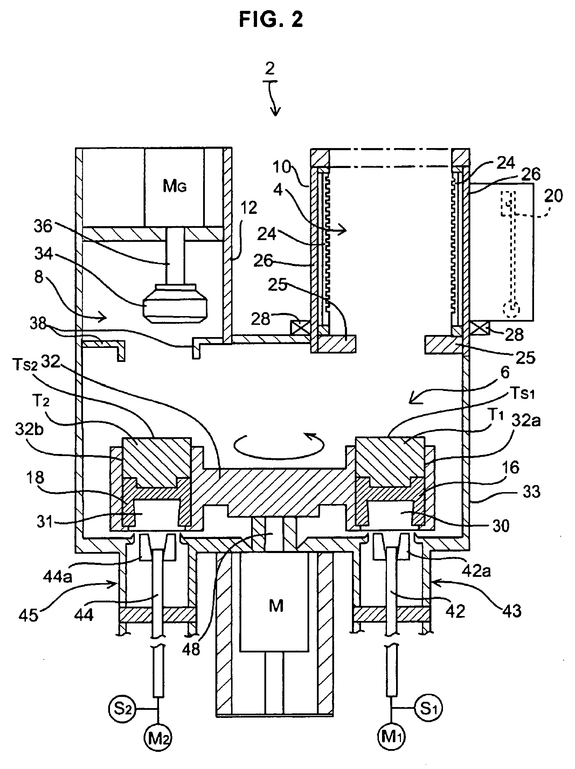

FIG. 2 is an apparatus cross-sectional view of target exchange type plasma generating apparatus 2 concerning the present invention, in a case that two auxiliary holders 16, 18 are received into main holder 32. Below, as for the reference numerals that have already been explained, their explanation is omitted. First spinning shaft 42 and second spinning shaft 44 are lowered by first slider S₁ and second slider S₂, with first chuck 42a and second chuck 44a in a closed state. Each chuck is pulled out of first joint 30 and the second joint, first auxiliary holder 16 is received in first containing portion 32a, and second auxiliary holder 18 in second containing portion 32b. Main holder 32 can half-rotate through main motor M as shown by the arrow, because each chuck 42a, 44a is located underneath the lowermost portion of main holder 32. Therefore, the target positions can be exchanged. These movement processes are described below.

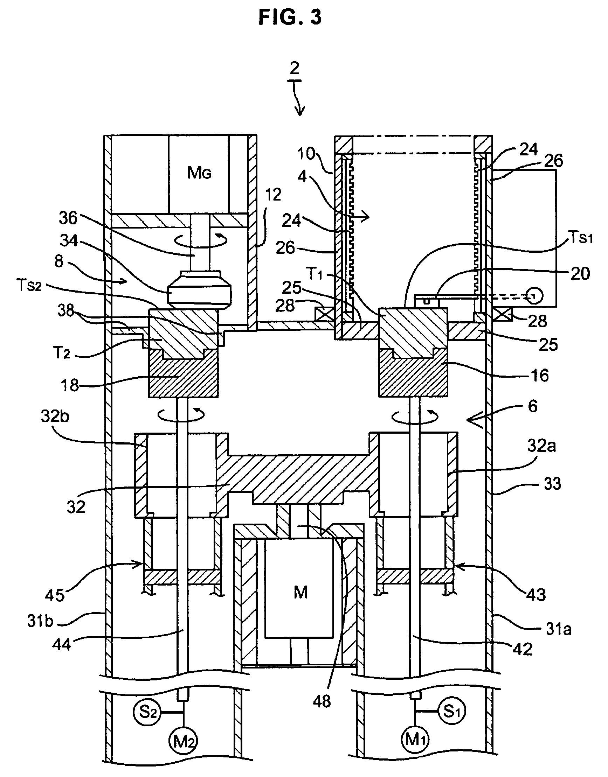

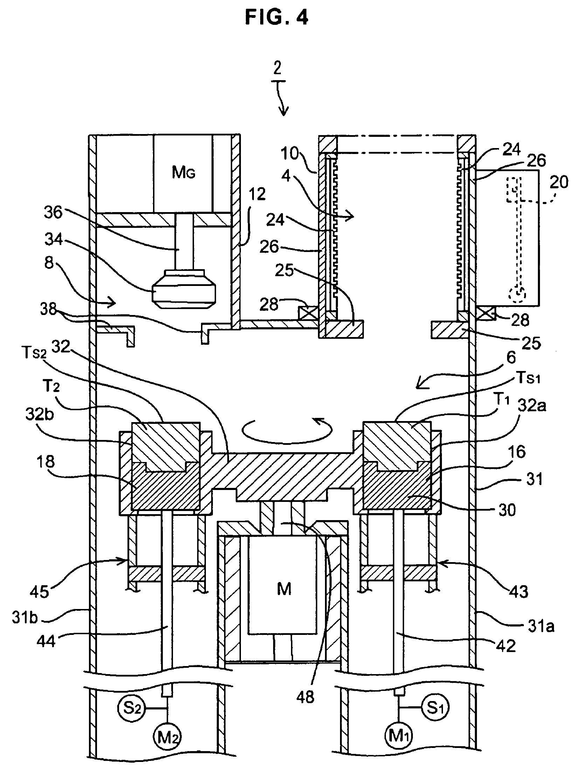

FIGS. 3 and 4 are apparatus cross-sectional views of target exchange type plasma generating apparatus 2 concerning the present invention, in a case that two holders 16, 18 are fixed to each spinning shaft 42, 44. In FIGS. 3 and 4, two auxiliary holder 16, 18 are fixed to each spinning shaft 42, 44. As shown in FIG. 4, auxiliary holders 16, 18 are contained in each containing portion 32a, 32b, and first and second spinning shafts 42, 44 end up rotating together with main holder 32 when the positions of first target T₁ and second target T₂ are exchanged. Therefore, spinning shaft outer walls 31 a, 31b are also formed in the shape of a tube, so that each spinning shaft 42, 44 could rotate.

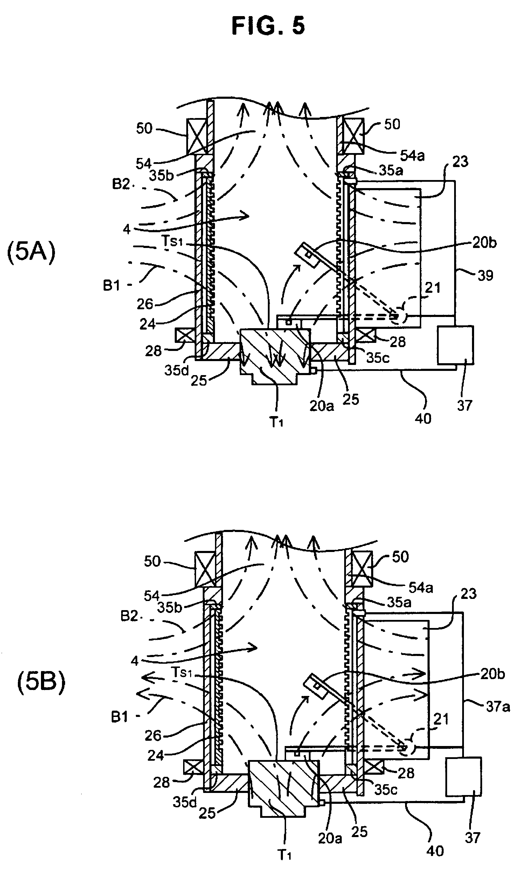

(5A) of FIG. 5 is a schematic cross-sectional view of the periphery of plasma generating portion 4 of target exchange type plasma generating apparatus 2 concerning the present invention. Voltage is applied by power supply 37 between anode inner wall 24 / striker 20a and first target T₁ through electric wires 39, 40. Outer wall 26 does not come in contact with anode inner wall 24, and its electrical neutrality is maintained by insulation members 35a, 35b. A vacuum arc discharge is induced between electric discharge surface T_{S1} and anode inner wall 24 by separating striker 20a at the contact position toward the direction of the position of striker 20b. Striker 20a (or 20b) is installed on rotating means 21, and when striker 20b in a distant position is made to come in contact with electric discharge surface T_{S1}, the torque reaction force of striker 20a coming in contact is detected by rotating means 21, thereby allowing a determination that the striker is in contact condition. Furthermore, filter coil 50 is arranged at the plasma outlet side of plasma generating portion 4, and plasma advancing magnetic field B1 is formed. Stabilizing magnetic field B1 that is generated by target coil 28 is formed in reverse-phase (cusp) with respect to plasma advancing magnetic field B2, enabling a generation of stable plasma. As shown in (5B), it is found that when stabilizing magnetic field B1 that is generated by target coil 28 is in-phase (mirror), the stability of the arc spot decreases, but the generation efficiency of plasma is improved.

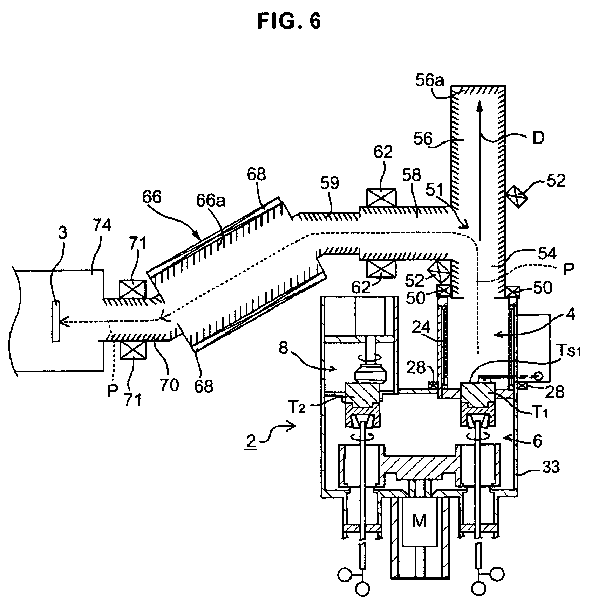

FIG. 6 is a schematic cross-sectional view of a plasma processing apparatus to which target exchange type plasma generating apparatus 2 concerning the present invention has been set up. At plasma generating portion 4, when vacuum arc plasma constituent particles such as target material ions, electrons, and cathode material neutral particles (atoms and molecules) are ejected by vacuum arc discharge, cathode material particles with size of less than submicron to several hundred microns (0.01-1000 µm) (henceforth referred to as "droplets D") are also ejected at the same time. The generated plasma P advances through plasma advancing path 54, and advances to the second advancing path by means of a magnetic field formed in bending portion 51 by bending magnetic field generators 52, 52. At that time, because droplets D are electrically neutral and not affected by magnetic field, they advance straightly through droplet advancing path 56, and are collected by droplet collecting portion 56a. Also, in the inner walls of droplet advancing path 56 and each advancing path of plasma P, baffles 59 and 66a to which droplets D collide and adhere are installed.

In the second advancing path, a second magnetic field generator that generates a plasma advancing magnetic field is set up, and plasma P advances. It advances through radially enlarged tube 66 in which multiple baffles 66a are installed in the inner wall, remaining droplets D collide and adhere to said baffles 66a, and droplets D are removed furthermore. Plasma P from which droplets D have been removed is supplied to plasma processing portion 74 by the magnetic field of third magnetic field generator 71, 71, and a plasma treatment of object to be treated 3 can be done. In target exchange type plasma generating apparatus 2 concerning the present invention, because the generation of plasma and the polishing of the electric discharge surface can be repeated intermittently by exchanging the two targets, plasma treatment can be done highly efficiently.

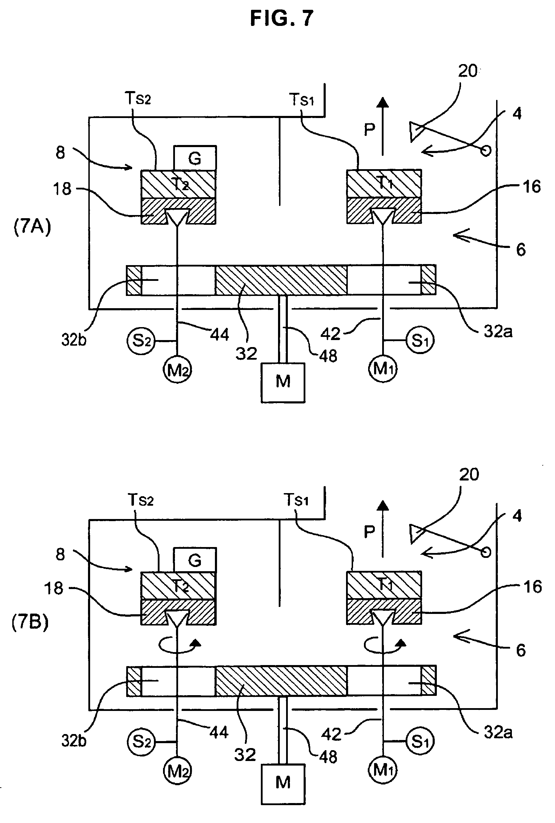

FIGS. 7 to 9 are explanatory drawings showing a movement process in target exchange type plasma generating apparatus 2 concerning the present invention, in a case in which each target T₁, T₂ is at the electric discharge position and the polishing position. In (7A), plasma P is generated while first target T₁ is in the electric discharge position of plasma generating portion 4. Second target T₂ is in the polishing position of target polishing portion 8, and it is ground by grinder G until electric discharge surface T_{S2} becomes an even plane. When the pore of electric discharge surface T_{S1} formed by generation of plasma P enlarges, and the generation efficiency of the plasma by the vacuum arc discharge falls, the first spinning shaft spins by the drive of motor M₁, the first target also spins through the first auxiliary holder, and it becomes possible for striker 20 to come in contact at a new position of electric discharge surface T_{S1}, as shown in (7B). Therefore, the generation efficiency of the plasma recovers, and plasma P of specified quantity can be generated. Therefore, on the electric discharge surface of first target T₁, multiple pores are formed. On the other hand, in target polishing portion 8, the position in which grinder G comes in contact with electric discharge surface T_{S2} can be changed by the spinning of second target T₂, and even if multiple pores are formed in second target T₂, these pores can be removed by grinding in grinder G.

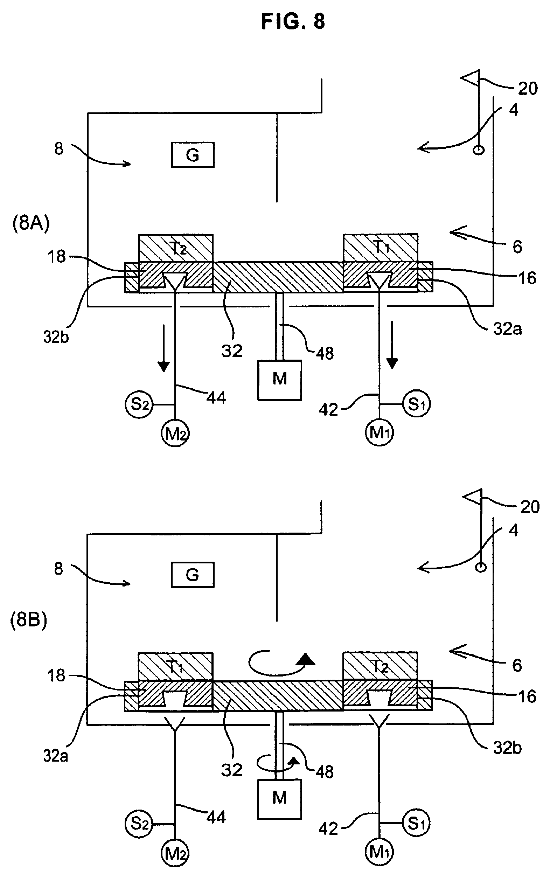

In (8A) of FIG. 8, target T₁ that has been fixed to first holder 16 and target T₂ that has been fixed to second holder 18 are lowered by sliders S₁, S₂, and are contained in each containing portion 32a, 32b of main holder 32. (8B) shows a condition in which each spinning shaft is lowered further from the state of (8A), and main holder 32 has been half-rotated by main motor M. The positions of each target and each auxiliary holder are exchanged.

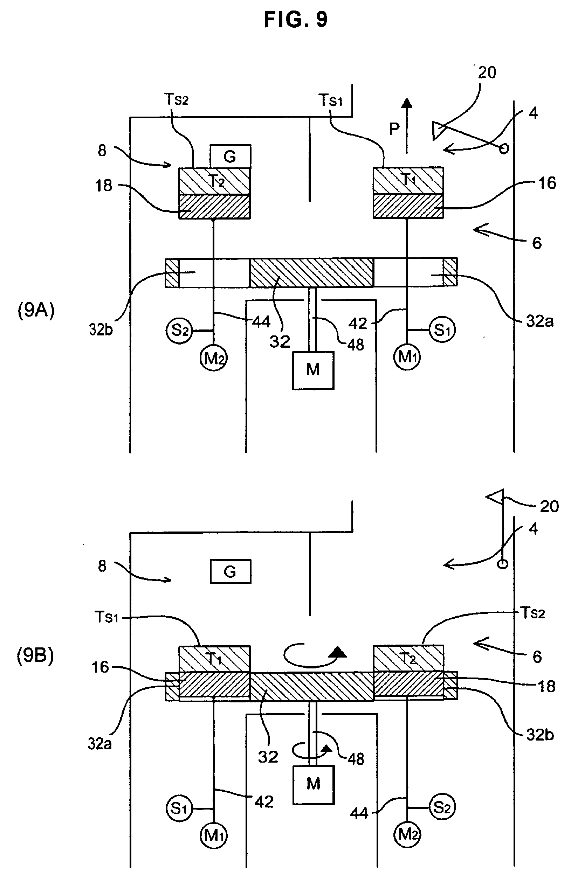

FIG. 9 is an explanatory drawing concerning the present invention, showing the movement process in a case where each spinning shaft is fixed to an auxiliary holder. The embodiment shown in FIG. 9 corresponds to the target exchange type plasma generating apparatus shown in FIGS. 3 and 4. Each target T₁, T₂ is lowered by each slider S₁, S₂ from the electric discharge position and the polishing position shown in (9A), contained in main holder 32, and half-rotated. In this case, the positions of each spinning shaft 42, 44, each auxiliary motor M₁, M₂, and each slider S₁, S₂ are also exchanged.

### INDUSTRIAL APPLICABILITY

According to target exchange type plasma generating apparatus concerning the present invention, a target exchange type plasma generating apparatus can be offered, in which the positions of the depleted target, to which multiple pores have been formed by plasma generation, and the polish-processed target can be exchanged, and also, the height of the two targets, and their contact position with the striker and such can be adjusted independently. For example, in a case where two kinds of target with different composition are set up, a target can be installed in a suitable location, depending on the quantity of consumption. Therefore, according to the present invention, vacuum arc plasma can be generated without opening the vacuum chamber, for a long time, continually or intermittently, and more stably, and thus a plasma processing apparatus that highly efficiently performs a film formation and a plasma treatment to an object to be treated can be provided.

## Claims

1. A target exchange type plasma generating apparatus (2) comprising
a plasma generating portion (4) that generates plasma (P) by a vacuum arc discharge between a target (T₁, T₂) becoming a cathode and an anode under a vacuum environment,
a target polishing portion (8) that polishes an electric discharge surface (T_{S1}, T_{S2}) of said target (T₁, T₂),
and a target exchanging mechanism (6) that exchanges the positions of a target (T₁, T₂) positioned at an electric discharge position of said plasma generating portion (4) and a target (T₁, T₂) positioned at a polishing position of said target polishing portion (8), wherein said target exchanging mechanism (6) comprises
a main holder (32) half-rotated by a main motor (M),
two containing portions (32a, 32b) installed in opposite positions along the diameter direction of said main holder (32),
**characterized by**
two auxiliary holders (16, 18) contained rotatably in said two containing portions (32a, 32b),
two auxiliary motors (M₁, M₂) spinning said two auxiliary holders (16, 18),
two sliders (S₁, S₂) raising and lowering said two auxiliary holders (16, 18) in the spinning shaft (42, 44) direction,
and said two targets (T₁, T₂) being engaged in said two auxiliary holders (16, 18), where the positions of said targets (T₁, T₂) are exchanged by half-rotating said main holder (32), and said two targets (T₁, T₂) are independently driven so that they are raised, lowered, and spun to said electric discharge position and said polishing position when said main holder (32) is stationary.

2. The target exchange type plasma generating apparatus (2) according to claim 1, wherein
connecting means (30, 31) removable from said auxiliary holders (16, 18) are installed at tips of said spinning shafts (42, 44),
said auxiliary motors (M₁, M₂) and said sliders (S₁, S₂) are separated from said main holder (32) at the detachment time of said connecting means (30, 31),
the positions of said targets (T₁, T₂) are exchanged by half-rotating only said main holder (32) that has received said auxiliary holders (16, 18),
said auxiliary holders (16, 18) are separated from said main holder (32) by raising said spinning shafts (42, 44) at the engagement time of said connecting means (30, 31), and each of said two targets (T₁, T₂) are independently deployed at said electric discharge position and said polishing position.

3. The target exchange type plasma generating apparatus (2) according to claim 2, wherein said connecting means (30, 31) comprises a chuck mechanism (42a, 44a).

4. The target exchange type plasma generating apparatus (2) according to claim 1, wherein
said auxiliary holders (16, 18) are fastened to tips of said spinning shafts (42, 44), each of said two targets (T₁, T₂) are positioned independently at said electric discharge position and said polishing position by raising said spinning shafts (42, 44) and separating said auxiliary holders (16, 18) from said main holder (32),
said auxiliary holders (16, 18) are contained inside said containing portions (32a, 32b) of said main holder (32) by lowering said spinning shafts (42, 44),
and said auxiliary motors (M₁, M₂) and said sliders (S₁, S₂) are half-rotated as a whole upon exchanging the positions of said targets (T₁, T₂) by half-rotating said main holder (32).

5. The target exchange type plasma generating apparatus (2) according to any one of claims 1-4, wherein
said plasma generating portion (4) is positioned in a plasma generation chamber sealed by an electric discharge partition wall (25) when said target (T₁, T₂) is positioned at said electric discharge position,
said target polishing portion (8) comprising a polishing device (10) is positioned in a target polishing chamber sealed by a polishing partition wall (38) when said target (T₁, T₂) is positioned at said polishing position,
and grinding powder that is ejected by said polishing device (10) from said target (T₁, T₂) is sealed in said polishing chamber.

6. The target exchange type plasma generating apparatus (2) according to any one of claims 1-5, wherein said plasma generating portion (4) is formed inside of an electrically neutral outer wall (26) and an anode inner wall (24) installed at the inner side of said outer wall (26).

7. The target exchange type plasma generating apparatus (2) according to claim 6, wherein
a target coil (28) is positioned at the outer circumference of said outer wall (26) tube at a vicinity position of said target (T₁, T₂),
a filter coil (50) is positioned at the plasma outlet side of said plasma generating portion (4),
and a stabilizing magnetic field (B₁) that is generated by said target coil (28) is formed in reverse-phase (cusp) or in-phase (mirror) of a plasma advancing magnetic field (B2) that is generated by said filter coil (50).

8. The target exchange type plasma generating apparatus (2) according to any one of claims 1-7, wherein
a striker (20, 20a, 20b) that induces an arc discharge on said electric discharge surface (T_{S1}, T_{S2}) of said target (T₁, T₂) is positioned at a vicinity of the target (T₁, T₂) positioned at said electric discharge position of said plasma generating portion (4),
said striker (20, 20a, 20b) is rotated around a fulcrum by a rotating means (21), and abutting of said striker tip against said electric discharge surface (T_{S1}, T_{S2}) is detected by measuring the torque reaction force on said striker (20, 20a, 20b).

## Patentansprüche

1. Plasmaerzeugungsvorrichtung (2) mit Zielaustausch, die Folgendes umfasst:
einen Plasmaerzeugungsabschnitt (4), der durch eine Vakuumbogenentladung zwischen einem Ziel (T₁, T₂), das eine Kathode und eine Anode wird, unter einer Vakuumumgebung ein Plasma (P) erzeugt,
einen Zielpolierabschnitt (8), der eine Elektroentladungsfläche (T_{S1}, T_{S2}) des Ziels (T₁, T₂) poliert,
und einen Zielaustauschmechanismus (6), der die Positionen eines an einer Elektroentladungsposition des Plasmaerzeugungsabschnitts (4) angeordneten Ziels (T₁, T₂) und eines an einer Polierposition des Zielpolierabschnitts (8) angeordneten Ziels (T₁, T₂) austauscht,
wobei der Zielaustauschmechanismus (6) Folgendes umfasst:
einen Haupthalter (32), der durch einen Hauptmotor (M) halb gedreht wird,
zwei Aufnahmeabschnitte (32a, 32b), die in gegenüberliegenden Positionen entlang der Durchmesserrichtung des Haupthalters (32) eingebaut sind,
**gekennzeichnet durch**
zwei Zusatzhalter (16, 18), die drehbar in den zwei Aufnahmeabschnitten (32a, 32b) aufgenommen werden,
zwei Zusatzmotoren (M₁, M₂), welche die zwei Zusatzhalter (16, 18) drehen,
zwei Gleitstücke (S₁, S₂), welche die zwei Zusatzhalter (16, 18) in der Richtung der Drehwelle (42, 44) anheben und absenken,
und zwei Ziele (T₁, T₂), die in den zwei Zusatzhaltern (16, 18) in Eingriff gebracht sind,
wobei die Positionen der Ziele (T₁, T₂) **durch** eine halbe Drehung des Haupthalters (32) ausgetauscht werden und die zwei Ziele (T₁, T₂) unabhängig angetrieben werden, so dass sie zu der Elektroentladungsposition und der Polierposition angehoben, abgesenkt und gedreht werden, wenn der Haupthalter (32) unbeweglich ist.

2. Plasmaerzeugungsvorrichtung (2) mit Zielaustausch nach Anspruch 1, wobei
Verbindungsmittel (30, 31), die von den Zusatzhaltern (16, 18) abgenommen werden können, an Spitzen der Drehwellen (42, 44) eingebaut sind,
die Zusatzmotoren (M₁, M₂) und die Gleitstücke (S₁, S₂) zum Ausrückzeitpunkt der Verbindungsmittel (30, 31) von dem Haupthalter (32) getrennt werden,
die Positionen der Ziele (T₁, T₂) durch eine halbe Drehung nur des Haupthalters (32), der die Zusatzhalter (16, 18) aufgenommen hat, ausgetauscht werden,
die Zusatzhalter (16, 18) zum Eingriffszeitpunkt der Verbindungsmittel (30, 31) durch das Anheben der Drehwellen (42, 44) von dem Haupthalter (32) getrennt werden,
und jedes der zwei Ziele (T₁, T₂) unabhängig bei der Elektroentladungsposition und der Polierposition eingesetzt werden.

3. Plasmaerzeugungsvorrichtung (2) mit Zielaustausch nach Anspruch 2, wobei die Verbindungsmittel (30, 31) einen Spannmechanismus (42a, 44a) umfassen.

4. Plasmaerzeugungsvorrichtung (2) mit Zielaustausch nach Anspruch 1, wobei
die Zusatzhalter (16, 18) an Spitzen der Drehwellen (42, 44) befestigt sind,
jedes der zwei Ziele (T₁, T₂) durch das Anheben der Drehwellen (42, 44) und das Trennen der Zusatzhalter (16, 18) von dem Haupthalter (32) unabhängig bei der Elektroentladungsposition und der Polierposition angeordnet werden,
die Zusatzhalter (16, 18) durch das Absenken der Drehwellen (42, 44) innerhalb der Aufnahmeabschnitte (32a, 32b) des Haupthalters (32) aufgenommen werden,
und die Zusatzmotoren (M₁, M₂) und die Gleitstücke (S₁, S₂) als ein Ganzes für das Austauschen der Positionen der Ziele (T₁, T₂) durch eine halbe Drehung des Haupthalters (32) hin halb gedreht werden.

5. Plasmaerzeugungsvorrichtung (2) mit Zielaustausch nach einem der Ansprüche 1 bis 4, wobei
der Plasmaerzeugungsabschnitt (4) in einer Plasmaerzeugungskammer angeordnet ist, die durch eine Elektroentladungstrennwand (25) abgedichtet wird, wenn das Ziel (T₁, T₂) an der Elektroentladungsposition angeordnet ist,
der Zielpolierabschnitt (8), der eine Poliereinrichtung (10) umfasst, in einer Zielpolierkammer angeordnet ist, die durch eine Poliertrennwand (38) abgedichtet wird, wenn das Ziel (T₁, T₂) an der Polierposition angeordnet ist,
und Schleifpulver, das durch die Poliereinrichtung (10) von dem Ziel (T₁, T₂) ausgestoßen wird, in der Polierkammer eingeschlossen wird.

6. Plasmaerzeugungsvorrichtung (2) mit Zielaustausch nach einem der Ansprüche 1 bis 5, wobei der Plasmaerzeugungsabschnitt (4) innerhalb einer elektrisch neutralen Außenwand (26) und einer Anodeninnenwand (24), die an der Innenseite der Außenwand (26) eingebaut ist, geformt ist.

7. Plasmaerzeugungsvorrichtung (2) mit Zielaustausch nach Anspruch 6, wobei
eine Zielspule (28) an dem Außenumfang der Röhre der Außenwand (26) an einer Nachbarschaftsposition des Ziels (T₁, T₂) angeordnet ist,
eine Filterspule (50) an der Plasmaauslassseite des Plasmaerzeugungsabschnitts (4) angeordnet ist,
und ein stabilisierendes Magnetfeld (B₁), das durch die Zielspule (28) erzeugt wird, in Umkehrphase (Spitze) oder phasengleich (Spiegel) mit einem Plasmavorschubmagnetfeld (B2), das durch die Filterspule (50) erzeugt wird, geformt ist.

8. Plasmaerzeugungsvorrichtung (2) mit Zielaustausch nach einem der Ansprüche 1 bis 7, wobei
eine Schlagvorrichtung (20, 20a, 20b), die eine Bogenentladung an der Elektroentladungsfläche (T_{S1}, T_{S2}) des Ziels (T₁, T₂) induziert, welches in der Nähe des Ziels (T₁, T₂), welches in der Nähe der Elektroentladungsposition des Plasmaerzeugungsabschnitts (4) angeordnet ist,
wobei die Schlagvorrichtung (20, 20a, 20b) durch ein Drehmittel (21) um einen Drehpunkt gedreht wird
und ein Anstoßen der Schlagvorrichtungsspitze gegen die Elektroentladungsfläche (T_{S1}, T_{S2}) durch das Messen der Drehmomentreaktionskraft an der Schlagvorrichtung (20, 20a, 20b) erfasst wird.

## Revendications

1. Appareil générateur de plasma du type à échange de cible (2), comprenant :
une portion génératrice de plasma (4) qui génère du plasma (P) par une décharge à arc sous vide entre une cible (T₁, T₂) qui devient une cathode et une anode sous environnement de vide,
une portion de polissage de cible (8) qui polit une surface de décharge électrique (T_{S1}, T_{S2}) de ladite cible (T₁, T₂), et
un mécanisme d'échange de cible (6) qui échange les positions d'une cible (T₁, T₂) située dans une position de décharge électrique de ladite portion génératrice de plasma (4) et d'une cible (T₁, T₂) située dans une position de polissage de ladite portion de polissage de cible (8),
dans lequel ledit mécanisme d'échange de cible (6) comprend :
un support principal (32) qui effectue une demi-rotation sous l'action d'un moteur principal (M),
deux portions de confinement (32a, 32b) installées dans des positions opposées le long de la direction diamétrale dudit support principal (32),
**caractérisé par**
deux supports auxiliaires (16, 18) confinés à rotation dans lesdites deux portions de confinement (32a, 32b),
deux moteurs auxiliaires (M₁, M₂) faisant tourner lesdits deux supports auxiliaires (16, 18),
deux curseurs (S₁, S₂) élevant et abaissant lesdits deux supports auxiliaires (16, 18) dans la direction de l'arbre rotatif (42, 44),
et lesdites deux cibles (T₁, T₂) étant engagées dans lesdits deux supports auxiliaires (16, 18), où les positions desdites cibles (T₁, T₂) sont échangées par demi-rotation dudit support principal (32), et lesdites deux cibles (T₁, T₂) sont indépendamment entraînées de sorte qu'elles soient soulevées, abaissées et tournées dans ladite position de décharge électrique et dans ladite position de polissage lorsque ledit support principal (32) est immobile.

2. Appareil générateur de plasma du type à échange de cible (2) selon la revendication 1, dans lequel :
des moyens de raccordement (30, 31) qui peuvent être retirés desdits supports auxiliaires (16, 18) sont installés aux pointes desdits arbres rotatifs (42, 44),
lesdits moteurs auxiliaires (M₁, M₂) et lesdits curseurs (S₁, S₂) sont séparés dudit support principal (32) au moment de la fixation desdits moyens de raccordement (30, 31),
les positions desdites cibles (T₁, T₂) sont échangées par une demi-rotation uniquement dudit support principal (32) qui a reçu lesdits supports auxiliaires (16, 18),
lesdits supports auxiliaires (16, 18) sont séparés dudit support principal (32) en soulevant lesdits arbres rotatifs (42, 44) au moment de l'engagement desdits moyens de raccordement (30, 31), et
chacune desdites deux cibles (T₁, T₂) est indépendamment déployée dans ladite position de décharge électrique et dans ladite position de polissage.

3. Appareil générateur de plasma du type à échange de cible (2) selon la revendication 2, dans lequel lesdits moyens de raccordement (30, 31) comprennent un mécanisme de serrage (42a, 44a).

4. Appareil générateur de plasma du type à échange de cible (2) selon la revendication 1, dans lequel :
lesdits supports auxiliaires (16, 18) sont fixés aux pointes desdits arbres rotatifs (42, 44), chacune desdites deux cibles (T₁, T₂) est positionnée indépendamment dans ladite position de décharge électrique et dans ladite position de polissage en soulevant lesdits arbres rotatifs (42, 44) et en séparant lesdits supports auxiliaires (16, 18) dudit support principal (32),
lesdits supports auxiliaires (16, 18) sont confinés dans lesdites portions de confinement (32a, 32b) dudit support principal (32) en abaissant lesdits arbres rotatifs (42, 44), et
lesdits moteurs auxiliaires (M₁, M₂) et lesdits curseurs (S₁, S₂) sont soumis à une demi-rotation dans leur ensemble lors de l'échange des positions desdites cibles (T₁, T₂) par demi-rotation dudit support principal (32).

5. Appareil générateur de plasma du type à échange de cible (2) selon l'une quelconque des revendications 1 à 4, dans lequel :
ladite portion génératrice de plasma (4) est positionnée dans une chambre génératrice de plasma scellée par une cloison de décharge électrique (25) lorsque ladite cible (T₁, T₂) est située dans ladite position de décharge électrique,
ladite portion de polissage de cible (8) comprenant un dispositif de polissage (10) est positionnée dans une chambre de polissage de cible scellée par une cloison de polissage (38) lorsque ladite cible (T₁, T₂) est située dans ladite position de polissage, et
la poudre de broyage qui est éjectée par ledit dispositif de polissage (10) de ladite cible (T₁, T₂) est scellée dans ladite chambre de polissage.

6. Appareil générateur de plasma du type à échange de cible (2) selon l'une quelconque des revendications 1 à 5, dans lequel ladite portion génératrice de plasma (4) est formée à l'intérieur d'une paroi externe électriquement neutre (26) et d'une paroi anodique interne (24) installée sur la face interne de ladite paroi externe (26).

7. Appareil générateur de plasma du type à échange de cible (2) selon la revendication 6, dans lequel :
une bobine cible (28) est située sur la circonférence externe du tube de ladite paroi externe (26) dans une position de voisinage avec ladite cible (T₁, T₂),
une bobine filtre (50) est située sur le côté de sortie de plasma de ladite portion génératrice de plasma (4), et
un champ magnétique de stabilisation (B₁) qui est généré par ladite bobine cible (28) est formé en phase inverse (rebroussement) ou en phase (miroir) d'un champ magnétique d'avancement de plasma (B₂) qui est généré par ladite bobine filtre (50).

8. Appareil générateur de plasma du type à échange de cible (2) selon l'une quelconque des revendications 1 à 7, dans lequel :
un percuteur (20, 20a, 20b) qui induit une décharge d'arc sur ladite surface de décharge électrique (T_{S1}, T_{S2}) de ladite cible (T₁, T₂) est situé au voisinage de la cible (T₁, T₂) positionnée dans ladite position de décharge électrique de ladite portion génératrice de plasma (4),
ledit percuteur (20, 20a, 20b) est soumis à une rotation autour d'un pivot par un moyen de rotation (21), et
l'aboutement de ladite pointe du percuteur contre ladite surface de décharge électrique (T_{S1}, T_{S2}) est détecté par mesure de la force de réaction du couple de torsion sur ledit percuteur (20, 20a, 20b).
